# EUROPÄISCHE PATENTSCHRIFT

(11) **EP 1 796 137 B1**
(45) Veröffentlichungstag und Bekanntmachung des Hinweises auf die Patenterteilung: **07.01.2015**
(21) Anmeldenummer: 06023023.2
(22) Anmeldetag: 06.11.2006
(51) Int. Cl.: H01L 23/00, H01L 21/683, H01L 25/00, H05K 1/09, H05K 3/10, H05K 3/32

(54) **Vorrichtung und getaktetes Verfahren zur Drucksinterverbindung**
Apparatus and clocked method for pressure sintering
Appareil et méthode cadencée pour frittage sous pression

(30) Priorität: 09.12.2005 DE 102005058794
(43) Veröffentlichungstag der Anmeldung: 13.06.2007
(73) Patentinhaber: Semikron Elektronik GmbH & Co. KG Patentabteilung, 90431 Nürnberg (DE)
(72) Erfinder: Göbl, Christian, 90441 Nürnberg (DE)

(56) Entgegenhaltungen:
- EP-A2- 0 330 896
- JP-A- 2004 296 746
- US-B1- 6 544 377
- CHRISTIAN MERTENS ED - MERTENS CHRISTIAN: "Die Niedertemperatur-Verbindungstechnik der Leistungselektronik", 1. Januar 2004 (2004-01-01), DIE NIEDERTEMPERATUR-VERBINDUNGSTECHNIK DER LEISTUNGSELEKTRONIK; [FORTSCHRITT-BERICHTE VDI : REIHE 21, ELEKTROTECHNIK ; 365], VDI VERLAG, DÜSSELDORF, GERMANY, PAGE(S) 1 - 35,72, XP002541611, ISBN: 978-3-18-336521-0 * Seite 1, Zeile 1 - Seite 5, Zeile 9; Abbildungen 2.2,2.5 * * Seite 6, Zeile 1 - Seite 6, Zeile 19 * * Seite 9, Zeile 17 - Seite 26, Zeile 15 *

## Beschreibung

Die Erfindung beschreibt eine Vorrichtung und ein Verfahren zur gleichzeitigen Drucksinterverbindung einer Mehrzahl von chipförmigen Bauelementen auf einem Substrat. Unter einem getakteten Drucksinterverfahren soll im Weiteren verstanden werden, dass hierbei nacheinander eine Mehrzahl von Substraten mit den jeweiligen Bauelementen einem zyklischen Verfahren in definierter Zeitabfolge mittels einer geeigneten Vorrichtung verbunden werden.

Grundlegenden Stand der Technik hierzu bilden die DE 34 14 065 C2 sowie die EP 0 242 626 B1. Weiterhin wird der Stand der Technik von Drucksinterverfahren umfassend beschrieben bei Mertens "Die Niedertemperatur-Verbindungstechnik der Leistungselektronik" ISBN 978-3-18-336521-0. Die DE 34 14 065 C2 offenbart ein Verfahren, das durch folgende wesentliche Verarbeitungsschritte gekennzeichnet ist:
- Aufbringen einer Mischung aus einem Metallpulver und einem Lösungsmittel, im weiteren als Sintermetall bezeichnet, bestehenden pastösen Schicht auf die zu verbindende Kontaktfläche des Bauelements oder des Substrats;
- Aufbringen des Bauelements auf das Substrat, wobei die pastöse Schicht zwischen dem Bauelement und dem Substrat angeordnet ist;
- Austreiben des Lösungsmittels aus dem Verbund aus Bauelement, pastöser Schicht und Substrat;
- Druckbeaufschlagung des Verbunds, vorzugsweise unter zusätzlicher Erwärmung auf Sintertemperatur, wobei die Drucksinterverbindung ausgebildet wird.

Dieses Verfahren ist hierbei für die Verbindung von genau einem Bauelement und einem zugeordneten Substrat offenbart. Die EP 0 242 626 B1 offenbart ein weiteres optimiertes Verfahren hierzu. Dieses Verfahren vermeidet Nachteile des erstgenannten Stands der Technik. Allerdings weist dieses Verfahren, wie auch das erstgenannte den Nachteil auf, dass es sich um ein rein serielles Verfahren handelt, das einer modernen und rationellen Fertigung derartiger Verbindungen entgegen steht.

Die ebenso zum Stand der Technik zählende DE 10 2004 019 567 offenbart Ansätze, das bis dato auf Einzelbauelemente und Einzelverbindungen beschränkte Drucksinterverfahren, einer automatisierbaren Fertigung leichter zugänglich zu machen. Hierbei wird in dieser Druckschrift speziell auf die Beschichtung der Bauelemente oder der Substrate mit dem Sintermetall abgestellt.
Weiterhin ist beispielhaft aus den Druckschrift US 6,544,377 B1 ein getaktete Verfahren mit einer Mehrzahl von Arbeitsstationen bekannt um Bauelemente der Elektrotechnik auf Substraten anzuordnen. Hierbei ist es besonders vorteilhaft, dass die unterschiedlichen Arbeitsstationen unterschiedliche Taktzyklen aufweisen können. Aus der JP 2004 296 746 A ist es bekannt beispielhaft für derartige Arbeitsstationen eine Druckeinrichtung vorzustellen, die eine gleichmäßige Druckeinleitung aufweist.

Der Erfindung liegt die Aufgabe zugrunde eine Vorrichtung und ein zugehöriges Verfahren vorzustellen, welche ein getaktetes Drucksinterverfahren einer Mehrzahl von Substraten mit jeweils einer Mehrzahl von chipförmigen Bauelementen erlauben.

Die Aufgabe wird erfindungsgemäß gelöst, durch die Maßnahmen der Merkmale der Ansprüche 1 und 5. Bevorzugte Ausführungsformen sind in den Unteransprüchen beschrieben.

Der erfinderische Gedanke geht aus von einem Substrat, vorzugsweise bestehend aus einem Grundkörper und einer hierauf angeordneten metallischen Schicht. Diese metallische Schicht weist vorzugsweise an ihrer Oberseite eine dünne Lage eines Edelmetalls auf, wie es als Basis von Drucksinterverbindungen besonders bevorzugt ist. Auf der metallischen Schicht des Substrats ist eine in einer Mehrzahl von chipförmigen Bauelementen angeordnet. Zwischen den Bauelementen und der metallischen Schicht ist gemäß dem Stand der Technik das Sintermetall in bekannter Schichtdicke und Ausprägung angeordnet.

Die Vorrichtung, die für ein getakteten Herstellungsverfahren von Drucksinterverbindungen geeignet ist, weist mindestens eine Pressvorrichtung, ein Transportband und einer Vorrichtung zur Abdeckung des Substrats mit einer Schutzfolie auf.

Die Pressvorrichtung ist derart ausgebildet, dass sie für den getakteten Betrieb geeignet ist. Sie weist hierzu einen Pressstempel und einen beheizbaren Presstisch auf. Das Transportband ist ausreichend druckstabil ausgebildet um während des Drucksinterprozesses zwischen dem Presstisch und dem Substrat zu verbleiben. Um die Substrate befördern zu können ist es direkt oberhalb des Presstischs verlaufend angeordnet. Die Schutzfolie ist zwischen dem Substrat mit den hierauf angeordneten Bauelementen und dem Pressstempel angeordnet ist.

Das zugehörige getaktete Verfahren zur Drucksinterverbindung einer Mehrzahl von chipförmigen Bauelementen mit einem Substrat mittels der genannten Vorrichtung besteht pro Taktzyklus aus den wesentlichen Schritten:
- Ein Substrat mit hierauf angeordneten Bauelementen wird mittels des Transportbands auf den Presstisch befördert.
- Mittels der Vorrichtung zur Abdeckung der Oberseite des Substrats mit hierauf angeordneten Bauelementen wird dieses mit einer Schutzfolie bedeckt.
- Der Pressstempel drückt auf den Verbund aus Folie, Bauelementen und Substrat wobei mittels des Gegendrucks durch den Presstisch die Drucksinterverbindung hergestellt wird.
- Anschließend wird der Druck gelöst und das Substrat wird mittels des Transportbands weiterbefördert.

Diese Verfahrensschritte werden zyklisch wiederholt, wodurch eine laufende Fertigung von Substraten mit hierauf mittels Drucksinterverfahren angeordneten Bauelementen erreicht wird.

Die erfinderische Lösung wird an Hand der Ausführungsbeispiele der Fig. 1 bis 3 weiter erläutert.

Fig. 1 zeigt eine Ausgestaltung einer erfindungsgemäßen Vorrichtung.

Fig. 2 zeigt ein Stadium des erfindungsgemäßen Verfahrens.

Fig. 3 zeigt ein weiteres Stadium des erfindungsgemäßen Verfahrens.

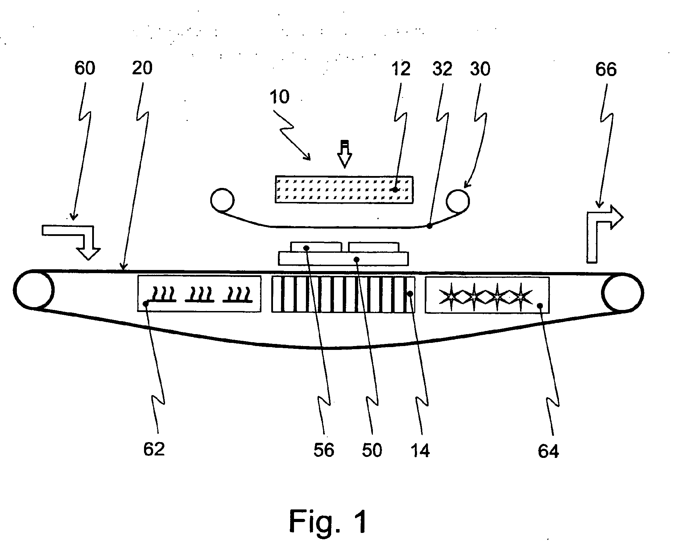

Fig. 1 zeigt eine Ausgestaltung einer erfindungsgemäßen Vorrichtung. Dargestellt ist hier die Pressvorrichtung (10), bestehend aus dem Pressstempel (12) und dem beheizbaren Presstisch (14), wobei dieser in seiner Lage unveränderbar ist und den Körper für Gegendruck für den beweglichen Pressstempel (12) bildet. Unmittelbar oberhalb des Presstischs (14) verläuft das Transportband (20), welches hier als Endlosband mit zwei Umlenkrollen dargestellt ist.

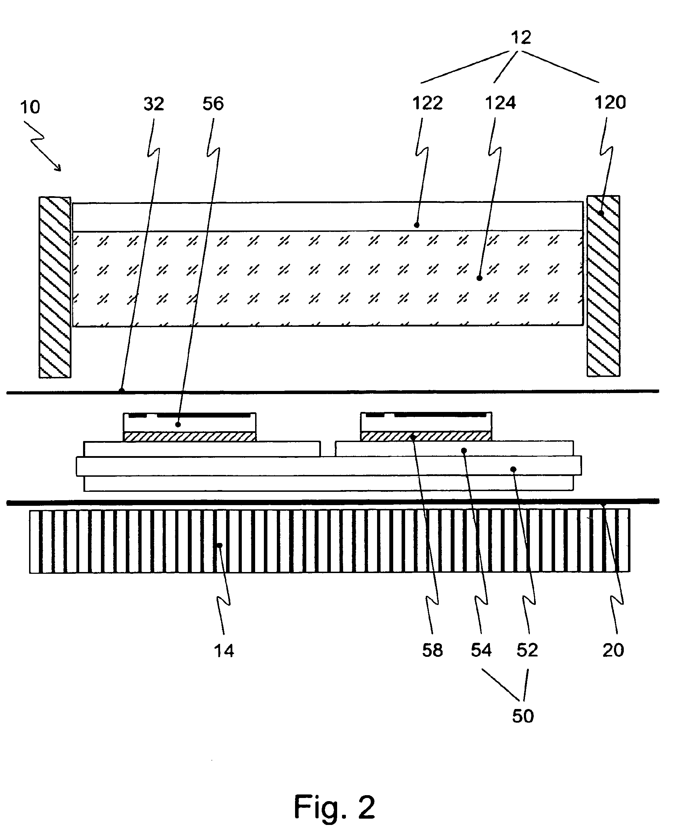

Weiterhin dargestellt ist die Vorrichtung (30) zur Abdeckung des Substrats (50) und der hierauf angeordneten chipförmigen Bauelemente (56) mit einer Schutzfolie (32). Diese Abdeckung dient dem Schutz des Pressstempels (12) vor Verunreinigung mit Sintermetall (vgl. Fig. 2, 58). In einem getakteten Verfahren würde diese Verschmutzung sich auf dem nächsten Substrat niederschlagen und somit zu einer Verunreinigung der Anlage und/oder der prozessierten Substrate und somit letztendlich zu einer Unterbrechung des kontinuierlichen Fertigungsverfahrens führen. Ein besonders geeignetes Verfahren für das Applizieren der Schutzfolie (32) ist hier dargestellt. Dabei ist die Schutzfolie (32) in einer Vorrichtung angeordnet, bei der sie von einer Seite der Pressvorrichtung (10) abgerollt und auf der anderen Seite wieder aufgerollt wird. Jedes Substrat (50) wird somit mit einem neuen Abschnitt der Schutzfolie (32) bedeckt.

Weiterhin dargestellt sind vorteilhafte Stationen der Vorrichtung. Zur Beladung des Transportbands dient eine Beladestation (60). Daran anschießend ist eine Vorheizstation (62) zum Temperatureintrag in das Substrat (50) vor der eigentlichen Pressvorrichtung (10) angeordnet. Nach der Pressvorrichtung (10) sind eine Abkühlstation (6) und eine anschließende Entladestation (66) angeordnet. All dieses Stationen sind mittels des Transportbands (20) verbunden.

Fig. 2 zeigt ein Stadium des erfindungsgemäßen Verfahrens. Dargestellt ist der Zeitpunkt an dem ein Substrat (50) bereits auf den Presstisch (14) befördert wurde. Das Substrat (50) ist hier ein Keramiksubstrat (52) mit metallischen Kaschierungen (54) auf beiden Hauptflächen. Derartige Substrate (50) werden vielfach für Leistungshalbleitermodule eingesetzt. Hierzu ist in der Regel die metallische Kaschierung (54) der den Bauelementen (56) zugeordnete Hauptfläche in sich strukturiert und bildet somit Leiterbahnen aus.

Auf diesen Leiterbahnen sind die chipförmigen Bauelemente (56) angeordnet. In Leistungshalbleitermodulen handelt es sich hierbei um Leistungshalbleiterbauelemente, wie Leistungsdioden, Leistungsthyristoren und / oder Leistungstransistoren.

Zwischen der metallischen Kaschierung (54) und den Bauelementen (56) ist das Sintermetall (58) angeordnet. Zur Drucksinterverbindung ist es besonders bevorzugt, wenn sowohl die metallische Kaschierung (54) und auch die zu verbindende Seite des Bauelements (56) eine Edelmetalloberfläche aufweisen.

Weiterhin ist ein Abschnitt des Transportbands (20) dargestellt. Dieses verläuft direkt oberhalb des Presstischs (14) und ist als ein Edelstahlband mit einer Dicke zwischen 0,2 mm und 1 mm ausgestaltet.

Oberhalb des Substrats (50) ist die Schutzfolie (32) dargestellt, die als eine Polytetrafluorethylenfolie mit einer Dicke zwischen 50 µm und 300 µm ausgestaltet ist. Es ist besonders bevorzugt, wenn die Schutzfolie (32) erst im Inneren der Pressvorrichtung (10) auf dem Substrat (50) mit den hierauf befindlichen Bauelementen (56) angeordnet wird. Alternativ kann die Schutzfolie (32) auch bereits vor der Pressvorrichtung (10) mittels einer zugeordneten Vorrichtung (30) angeordnet werden.

Der Pressstempel (12) der Pressvorrichtung (10) weist einen beweglichen Rahmen (120) und ein davon unabhängiges bewegliches an einem Stempel (122) angeordnetes Druckkissen (124) aus einer Silikonverbindung auf.

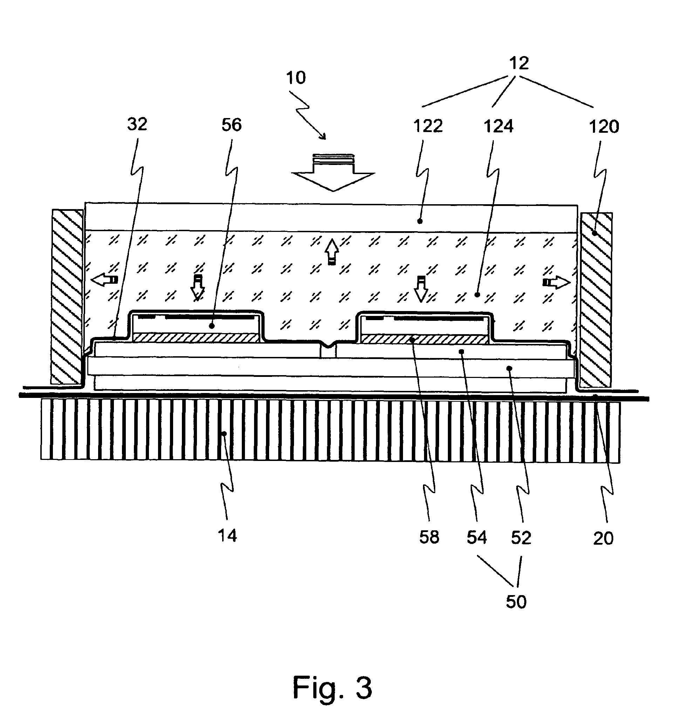

Fig. 3 zeigt einen weiteren Schritt des erfindungsgemäßen Verfahrens. Hierbei ist der bewegliche Rahmen (120) des Pressstempels (12) bis auf das Transportband (20) abgesenkt. Hierbei wird das Transportband (20) auf den Presstisch (14) gedrückt und in einem weiteren Schritt erfolgt die Absenkung des Druckkissens (124) auf die Schutzfolie (32), die hierbei an die Kontur des Substrats (50) mit darauf angeordneten Bauelementen (56) angepasst wird. Durch weitere Druckerhöhung auf das Druckkissen (124) von 30 bis 60 N/mm² wird die Drucksinterverbindung zwischen den Bauelementen (56) und den Leiterbahnen (54) gebildet.

Hierbei erfolgt die Druckeinleitung quasihydrostatische, da das Druckkissen (122) aus einer Silikonverbindung besteht und diese unter Druck ein Fließverhalten zeigt das mit einer Flüssigkeit vergleichbar ist. Diese quasihydrostatische Druckverteilung auf alle Oberflächen bewirkt einerseits eine Drucksihterverbindung aller-Bäuelemente (56) ohne anderseits das Substrat (50) zu beschädigen.

## Patentansprüche

1. Vorrichtung für ein getaktetes Verfahren zur Drucksinterverbindung von chipförmigen Bauelementen (56) mit Leiterbahnen (54) eines jeweiligen Substrats (50), mindestens bestehend aus einer Pressvorrichtung (10), einem Transportband (20) und einer Vorrichtung (30) zur Abdeckung des Substrats (50) mit einer Schutzfolie (32), wobei die Pressvorrichtung (10) für den getakteten Betrieb geeignet ist, einen Pressstempel (12) und einen beheizbaren Presstisch (14) aufweist, wobei die chipförmigen Bauelemente (56) Leistungshalbleiterbauelemente, wie Leistungsdioden, Leistungsthyristoren und / oder Leistungstransistoren sind und das Substrat (50) ein Keramiksubstrat (52) mit metallischen Kaschierungen (54) auf beiden Hauptflächen ist,
**dadurch gekennzeichnet, dass**
das Transportband (20), ein Edelstahlband mit einer Dicke zwischen 0,2 mm und 1 mm, ausreichend druckstabil, für einen Druck von 30 bis 60 N/mm², ist und oberhalb des Presstischs (14) verlaufend angeordnet ist und
die Schutzfolie (32), eine Polytetrafluorethylenfolie mit einer Dicke zwischen 50 µm und 300 µm ist, die zwischen dem Substrat (50) mit den hierauf angeordneten Bauelementen (56) und dem Pressstempel (12) angeordnet ist.

2. Vorrichtung nach Anspruch 1,
wobei der Pressstempel (12) einen beweglichen Rahmen (120) und ein davon unabhängig bewegliches Druckkissen (124) aus einer Silikonverbindung aufweist, die eine quasihydrostatische Druckverteilung auf alle Oberflächen aufweist.

3. Vorrichtung nach Anspruch 1,
wobei vor der Pressvorrichtung (10) eine Beladestation (60), eine Vorheizstation (62) zum Temperatureintrag in das Substrat (50) und nach der Pressvorrichtung (10) eine Abkühlstation (64) und eine Entladestation (66) angeordnet sind und all dieses Stationen mittels des Transportbands (20) verbunden sind.

4. Getaktetes Verfahren zur Drucksinterverbindung einer Mehrzahl von chipförmigen Bauelementen (56) mit einer Leiterbahn (54) des Substrats (50) mittels einer Vorrichtung gemäß den Ansprüchen 1 bis 3,
wobei pro Taktzyklus
• ein Substrat (50) mit auf dessen Leiterbahnen (54) angeordneten Bauelementen (56) mittels des Transportbands (20) auf den Presstisch (14) befördert wird;
• mittels der Vorrichtung (30) zur Abdeckung der Oberseite des Substrats (50) mit hierauf angeordneten Bauelementen (56) diese mit einer Schutzfolie (32) bedeckt werden;
• der Pressstempel (12) auf den Verbund aus Folie (32), Bauelementen (56) und Substrat (50) drückt und mittels des Gegendrucks durch den Presstisch (14) die Drucksinterverbindung hergestellt wird;
• der Druck gelöst wird und mittels des Transportbands (20) das Substrat (50)
weiterbefördert wird;
und wobei sich diese Verfahrensschritte zyklisch wiederholen.

5. Verfahren nach Anspruch 4,
wobei das Substrat (50) mit den hierauf angeordneten Bauelementen (56) mittels der zugeordneten Vorrichtung (30) vor der Pressvorrichtung (10) oder im Inneren der Pressvorrichtung (10) mit der Schutzfolie (32) bedeckt wird.

6. Verfahren nach Anspruch 4,
wobei ein beweglicher Rahmen (120) des Pressstempel (12) bis auf das Transportband (20) abgesenkt wird und anschließend ein Druckkissen (124) auf die Schutzfolie (32) abgesenkt wird und mittels dieses Druckkissens (124) eine quasihydrostatische Druckeinleitung über die Schutzfolie (32) auf die Bauelemente (56) und das Substrat (50) eingeleitet wird.

## Claims

1. Apparatus for a clocked method for the pressure-sintered bonding of chip-like components (56) to conductive tracks (54) of a respective substrate (50), consisting at least of a pressing apparatus (10), a conveyor belt (20) and an apparatus (30) for covering the substrate (50) with a protective film (32), the pressing apparatus (10) being suitable for clocked operation, and comprising a pressing die (12) and a heatable pressing table (14), wherein the chip-like components (56) are power semiconductor components such as power diodes, power thyristors and/or power transistors, and the substrate (50) is a ceramic substrate (52) with metal masks (54) on both main surfaces,
**characterized in that**
the conveyor belt (20), is a stainless steel belt with a thickness of between 0.2 mm and 1 mm that is sufficiently pressure-stable for a pressure of from 30 to 60 N/mm², and is arranged running above the pressing table (14), and
the protective film (32) is a polytetrafluoroethylene film with a thickness of between 50 µm and 300 µm, which is arranged between the substrate (50) with the components (56) arranged thereon and the pressing die (12).

2. Apparatus according to Claim 1,
wherein the pressing die (12) comprises a mobile frame (120) and a pressure cushion (124), consisting of a silicone compound and movable independently therefrom, which has a quasihydrostatic pressure distribution on all surfaces.

3. Apparatus according to Claim 1,
wherein a loading station (60) and a preheating station (62) for raising the temperature of the substrate (50) are arranged before the pressing apparatus (10), and a cooling station (64) and an unloading station (66) are arranged after the pressing apparatus (10), and all these stations are joined by means of the conveyor belt (20).

4. Clocked method for the pressure-sintered bonding of a multiplicity of chip-like components (56) to a conductive track (54) of the substrate (50) by means of an apparatus according to Claims 1 to 3,
wherein, for each clock cycle,
• a substrate (50) with components (56) arranged on its conductive tracks (54) is conveyed onto the pressing table (14) by means of the conveyor belt (20) ;
• by means of the apparatus (30) for covering the upper side of the substrate (50) with components (56) arranged thereon, the latter are covered with a protective film (32);
• the pressing die (12) presses on the assembly consisting of a film (32), components (56) and substrate (50), and the pressure-sintered bonding is established by means of the counterpressure due to the pressing table (14);
• the pressure is released and the substrate (50) is conveyed onward by means of the conveyor belt (20); and wherein these method steps are repeated cyclically.

5. Method according to Claim 4,
wherein the substrate (50) with the components (56) arranged thereon is covered with the protective film (32) by means of the assigned apparatus (30) before the pressing apparatus (10) or inside the pressing apparatus (10).

6. Method according to Claim 4,
wherein a mobile frame (120) of the pressing die (12) is lowered onto the conveyor belt (20) and a pressure cushion (124) is subsequently lowered onto the protective film (32), and quasihydrostatic pressurisation is induced by means of this pressure cushion (124) over the protective film (32) onto the components (56) and the substrate (50).

## Revendications

1. Liaison par frittage sous pression de composants (56) en forme de puce à des pistes conductrices (54) d'un substrat associé (50),
le dispositif étant constitué au moins d'un dispositif de poussée (10), d'une bande transporteuse (20) et d'un dispositif (30) de recouvrement du substrat (50) par une feuille de protection (32),
le dispositif de poussée (10) pouvant être conduit de manière cadencée, présentant un poussoir (12) et une table de poussée (14) aptes à être chauffée,
les composants (56) en forme de puce étant des composants semi-conducteurs de puissance, par exemple des diodes de puissance, des thyristors de puissance et/ou des transistors et
le substrat (50) étant un substrat céramique (52) doté de masques métalliques (54) sur ses deux surfaces principales,
**caractérisée en ce que**
la bande transporteuse (20), qui est une bande en acier allié d'une épaisseur comprise entre 0,2 mm et 1 mm, suffisamment résistante à la pression pour reprendre une pression de 30 à 60 N/mm², est disposée de manière à se déplacer au-dessus de la table de poussée (14) et
**en ce que** la feuille de protection (32) est une feuille de polytétrafluoroéthylène d'une épaisseur comprise entre 50 µm et 300 µm disposée entre le poussoir (12) et le substrat (50) sur lequel sont disposés les composants (56).

2. Dispositif selon la revendication 1, dans lequel le poussoir (12) présente un bâti mobile (120) et un coussin de poussée (124) en un composé de silicone qui présente une répartition quasi hydrostatique de la poussée sur toute sa surface et apte à être déplacé indépendamment du bâti.

3. Dispositif selon la revendication 1, dans lequel un poste de chargement (60) et un poste de préchauffage (62) permettant d'augmenter la température du substrat (50) sont disposés en amont du dispositif de poussée (10) et un poste de refroidissement (64) et un poste de déchargement (66) sont disposés en aval du dispositif de poussée (10), tous ces postes étant reliés au moyen de la bande transporteuse (20).

4. Procédé cadencé de liaison par frittage sous pression de plusieurs composants (56) en forme de puce avec une piste conductrice (54) du substrat (50) au moyen d'un dispositif selon les revendications 1 à 3, et dans lequel au cours de chaque cycle cadencé :
un substrat (50) sur les pistes conductrices (54) duquel sont disposés les composants (56) est transporté sur la table de poussée (14) au moyen de la bande transporteuse (20),
au moyen du dispositif (30) de recouvrement du côté supérieur du substrat (50) sur lequel sont disposés les composants (56), ces derniers sont recouverts d'une feuille de protection (32),
le poussoir (12) est repoussé sur l'ensemble constitué de la feuille (32), des composants (56) et du substrat (50) et la liaison par frittage sous pression est formée au moyen de la contre-pression exercée par la table de poussée (14) et
la poussée est supprimée et le substrat (50) est évacué au moyen de la bande transporteuse (20),
ces étapes du procédé se répétant de manière cyclique.

5. Procédé selon la revendication 4, dans lequel le substrat (50) sur lequel sont disposés les composants (56) est recouvert de la feuille de protection (32) au moyen du dispositif (30) associé, en amont du dispositif de poussée (10) ou à l'intérieur du dispositif de poussée (10).

6. Procédé selon la revendication 4, dans lequel un bâti mobile (120) du poussoir (12) est abaissée jusque sur la bande transporteuse (20) et un coussin de poussée (124) est ensuite abaissée sur la feuille de protection (32), une pression quasi-hydrostatique étant appliquée au moyen de ce coussin de poussée (124) sur les composants (56) et le substrat (50) par l'intermédiaire du film de protection (32).
